# EUROPÄISCHE PATENTSCHRIFT

(11) **EP 4 409 631 B1**
(45) Veröffentlichungstag und Bekanntmachung des Hinweises auf die Patenterteilung: **08.10.2025**
(21) Anmeldenummer: 22765070.2
(22) Anmeldetag: 11.08.2022
(51) Int. Cl.: H01L 23/473

(54) **KÜHLER ZUM KÜHLEN EINER LEISTUNGSELEKTRONIK**
COOLER FOR COOLING POWER ELECTRONICS
REFROIDISSEUR POUR L'ÉLECTRONIQUE DE PUISSANCE

(30) Priorität: 30.09.2021 DE 102021210934
(43) Veröffentlichungstag der Anmeldung: 07.08.2024
(73) Patentinhaber: Robert Bosch GmbH, 70442 Stuttgart (DE)
(72) Erfinder: BECK, Max Florian, 71665 Vaihingen An Der Enz (DE); PAEHRISCH, Maik, 72766 Reutlingen (DE)
(86) Internationale Anmeldenummer: PCT/EP2022/072563
(87) Internationale Veröffentlichungsnummer: WO 2023/051989

(56) Entgegenhaltungen:
- WO-A1-2019/189477
- WO-A1-2019/210413
- JP-A- 2010 203 694
- US-A1- 2015 189 791

## Beschreibung

### Stand der Technik

Die vorliegende Erfindung betrifft einen Kühler zum Kühlen einer Leistungselektronik. Des Weiteren zeigt die Erfindung eine Anordnung umfassend den Kühler samt der Leistungselektronik.

Leistungshalbleiter in einer Leistungselektronik führen hohe elektrische Ströme. Zusammen mit Schaltverlusten sind die daraus resultierenden Leitverluste ursächlich für eine hohe Verlustwärmeleistung, welche auf einer relativ kleinen Fläche abzuführen ist. Die maximal zulässige Halbleitertemperatur ist dabei versagenskritisch, weshalb eine Minimierung des thermischen Widerstands zwischen Halbleiter und Kühlmittel von zentraler Bedeutung ist. Zur effizienten Kühlung wird die hier betrachtete Leistungselektronik auf fluiddurchströmten Kühlern appliziert. In diesen Kühlern befinden sich üblicherweise Kühlrippenanordnungen, durch die das Fluid strömt.

Bekannte Kühler für Leistungselektroniken sind in WO 2019/210413 A1, WO 2019/189477 A1, US 2015/189791 A1, und JP 2010 203694 A offenbart.

### Offenbarung der Erfindung

Der erfindungsgemäße Kühler ermöglicht eine schnelle und einfache Fertigung, wobei insbesondere die Kühlrippenanordnung durch ihre einteilige Ausgestaltung schnell gefertigt und fehlerfrei eingelegt werden kann. Des Weiteren ermöglicht der erfindungsgemäße Kühler eine sehr effiziente Kühlung der Leistungselektronik. Der erfindungsgemäße Kühler ist insbesondere zum Kühlen einer Leistungselektronik ausgebildet. Diese Leistungselektronik weist einen oder mehrere Leistungshalbleiter auf, die üblicherweise in einem Substrat angeordnet sind. Der Kühler umfasst ein Gehäuse, das zum Aufsetzen der Leistungselektronik ausgebildet ist. Vorzugsweise ist das Gehäuse plattenförmig ausgestaltet, beispielsweise mit zwei Kühlplatten, welche zwischen sich einen Kühlkanal definieren, welcher von Kühlfluid durchströmt werden kann. Der Kühlkanal bildet dabei einen Hohlraum. In diesem Hohlraum befindet sich eine Kühlrippenanordnung mit einer Vielzahl an Kühlrippen. Bei der Kühlrippenanordnung handelt es sich insbesondere um ein Einlegeteil, das zwischen die beiden Kühlplatten eingelegt wird. Der Kühlkanal sowie die Kühlrippenanordnung sind zum Durchleiten des kühlenden Fluides ausgebildet. Es wird insbesondere mit einem Fluid im flüssigen Aggregatszustand gekühlt.

Die Kühlrippenanordnung ist so ausgebildet, dass sie entlang einer Längsachse mit dem Fluid durchströmbar ist. Senkrecht zu der Längsachse und somit auch senkrecht zur Strömungsrichtung ist eine Querachse definiert. Senkrecht zur Querachse und senkrecht zur Längsachse ist eine Hochachse definiert.

Insbesondere erstreckt sich die Kühlrippenanordnung in Richtung der Längsachse und in Richtung der Querachse wesentlich weiter als in Richtung der Hochachse. Die Leistungselektronik ist entlang der Hochachse über oder unter der Kühlrippenanordnung positioniert. Entlang der Längsachse und zum Teil auch entlang der Querachse können mehrere Wärmequellen der Leistungselektronik, insbesondere mehrere der Leistungshalbleiter, positioniert werden. Die Kühlrippenanordnung weist mehrere Kühlrippenabschnitte auf.

Insbesondere handelt es sich um zwei bis zehn unterschiedliche Kühlrippenabschnitte. Jeweils zwei benachbarte Kühlrippenabschnitte weisen unterschiedliche Geometrien der Rippen auf. Wie noch im Detail erläutert wird, kann die Kühlrippenanordnung zwischen zwei Kühlrippenabschnitten einen Zwischenabschnitt umfassen. Auch der Zwischenabschnitt kann Kühlrippen aufweisen. Die gesamte Kühlrippenanordnung ist ein einziges Bauteil, das eingelegt wird. Dementsprechend sind sämtliche Kühlrippenabschnitte der Kühlrippenanordnung fest miteinander verbunden. Benachbarte Kühlrippenabschnitte können dabei unmittelbar miteinander fest verbunden sein oder über die erwähnten Zwischenabschnitte miteinander fest verbunden sein.

Bevorzugt ist vorgesehen, dass der hier beschriebene Kühler nur eine Kühlrippenanordnung aufweist. Allerdings ist es auch möglich, dass zusätzlich zu der hier beschriebenen Kühlrippenanordnung mit den mehreren Kühlrippenabschnitten noch weitere Kühlrippenanordnungen eingelegt werden.

Die feste Verbindung aller Kühlrippenabschnitte der Kühlrippenanordnung hat zum Vorteil, dass lediglich ein Bauteil eingelegt werden muss. Des Weiteren ist durch die feste Verbindung der Kühlrippenabschnitte untereinander auch der Abstand zwischen den Kühlrippenabschnitten, beispielsweise durch die Zwischenabschnitte, festgelegt und kann bei der Montage nicht mehr fälschlicherweise verändert werden. Die einzelnen Kühlrippenabschnitte können bei der Montage nicht mehr vertauscht oder verdreht werden, da deren gegenseitige Ausrichtung durch die feste Verbindung untereinander festgelegt ist. Als Material für die Kühlrippenanordnung wird vorzugsweise Aluminium oder ein anderes Material mit entsprechend hoher Wärmeleitfähigkeit bzw. entsprechender Beschichtung verwendet. Ferner ist vorgesehen, dass die Rippen mit einem Anstellwinkel zur Längsachse angestellt sind und sich der Anstellwinkel in zumindest zwei benachbarten Kühlrippenabschnitten unterscheidet. Dabei ist vorgesehen, dass der Anstellwinkel von einem Kühlrippenabschnitt zum nächsten Kühlrippenabschnitt entlang der Strömungsrichtung zunimmt. Der jeweilige Kühlrippenabschnitt weist vorzugsweise mehrere hintereinander angeordnete Rippenreihen auf. Die Rippenreihen erstrecken sich, wie im Rahmen des Turbulenzblechs beschrieben, entlang der Querachse und liegen entlang der Längsachse unmittelbar aneinander an. Vorzugsweise sind die Rippen in benachbarten Rippenreihen mit unterschiedlichen Anstellungsrichtungen gegen die Längsachse angestellt, so dass beispielsweise die Rippen der einen Reihe mit 10° und die Rippen der nächsten Reihe mit -10° gegenüber der Längsachse angestellt sind. Durch dieses wechselseitige Anstellen der Rippen wird der Strömungswiderstand bewusst erhöht, um einen möglichst hohen Wärmeübergangskoeffizienten zu erreichen.

Die Unteransprüche zeigen bevorzugte Weiterbildungen der Erfindung.

Grundsätzlich ist es möglich, die einzelnen Kühlrippenabschnitte bzw. auch die Zwischenabschnitte nach deren Fertigung miteinander fest zu verbinden. Besonders bevorzugt ist jedoch vorgesehen, dass die Kühlrippenanordnung aus einem Teil gefertigt ist. Insbesondere wird die Kühlrippenanordnung durch Umformen eines Blechs zu einem Turbulenzblech gefertigt. Dabei entstehen aus dem einen Blech alle Kühlrippenabschnitte und gegebenenfalls die Zwischenabschnitte der Kühlrippenanordnung, so dass nach dem Umformen des Blechs eine Kühlrippenanordnung vorliegt, die aus einem Teil, nämlich dem einen Blech, gefertigt ist und in der sämtliche Kühlrippenabschnitte fest miteinander verbunden sind, entweder direkt miteinander verbunden sind oder über die Zwischenabschnitte miteinander verbunden sind.

Das Turbulenzblech weist insbesondere eine Vielzahl an Rippenreihen auf. Die einzelne Rippenreihe erstreckt sich senkrecht zur Längsachse entlang der Querachse. Die einzelne Rippenreihe weist eine Vielzahl an Rippen auf. Insbesondere weist die Rippenreihe eine Wellenform auf. Durch diese Wellenform sind jeweils zwei benachbarte Rippen über einen Berg- oder Talabschnitt der Wellenform miteinander verbunden. Der Berg- oder Talabschnitt der Wellenform bzw. die Rippenreihe erstreckt sich insbesondere im Wesentlichen in einer durch die Längsachse und Querachse aufgespannten Ebene.

Die Zwischenabschnitte erstrecken sich in Längsrichtung vorzugsweise wesentlich kürzer als die Kühlrippenabschnitte. Der einzelne Zwischenabschnitt kann vorzugsweise durch eine Rippenreihe gebildet sein. Dabei ist vorzugsweise vorgesehen, dass in zumindest einem Kühlrippenabschnitt die Rippen eine erste Länge, gemessen parallel zur Längsachse, aufweisen und der benachbarte Zwischenabschnitt eine zweite Länge, ebenfalls gemessen parallel zur Längsachse, aufweist. Die zweite Länge ist dabei größer als die erste Länge; der gesamte Zwischenabschnitt ist somit länger als eine einzelne Rippe des benachbarten Kühlrippenabschnitts.

Für die Fertigung der Kühlrippenanordnung, insbesondere durch Umformen eines Blechs zu einem Turbulenzblech, wird vorzugsweise die Geometrie der einzelnen Kühlrippenabschnitte beachtet. So ist es von Vorteil, wenn die Kühlrippenanordnung über alle Kühlrippenabschnitte und Zwischenabschnitte hinweg eine konstante Materialdicke und/oder eine konstante Rippenhöhe und/oder eine konstante Periodenlänge aufweist. Die Materialdicke ist durch die Stärke des verarbeiteten Blechs gegeben. Die Rippenhöhe wird entlang der Hochachse gemessen. Die Periodenlänge wird entlang der Querachse innerhalb einer Rippenreihe gemessen.

Bei der Konstruktion des Kühlers wurde bedacht, dass das Kühlmittel in Strömungsrichtung durch die Verlustwärme der Leistungshalbleiter erwärmt wird. Dadurch wird der bezüglich der Strömungsrichtung hinten liegende Leistungshalbleiter schlechter gekühlt als der vorderste, was zu unterschiedlichen Lebensdauern und vor allem unterschiedlichem elektrischem Verhalten führt. Deshalb sind die verschiedenen Kühlrippenabschnitte vorzugsweise entlang der Längsrichtung und somit entlang der Strömungsrichtung hintereinander angeordnet, so dass sich entlang der Strömungsrichtung die Geometrien der Rippen ändern. Dadurch kann der Wärmeübergangskoeffizient zwischen Rippen und Kühlmittel angepasst werden.

Auf unterschiedliche Weise kann erreicht werden, dass sich der Strömungswiderstand von einem Kühlrippenabschnitt zum nächsten Kühlrippenabschnitt erhöht und sich dadurch auch der Wärmeübergangskoeffizient erhöht:
Zusätzlich zur Steigerung des Anstellwinkels von einem Kühlrippenabschnitt zum nächsten Kühlrippenabschnitt kann der Strömungswiderstand auch dadurch erhöht werden, dass die Länge der einzelnen Rippe, gemessen entlang der Längsachse, verringert wird. Dies ist insbesondere in Kombination mit der oben beschriebenen wechselnden Anstellungsrichtung der einzelnen Rippenreihen von Interesse, da bei dieser wechselnden Anstellungsrichtung und entsprechend kurzen Rippen (gemessen parallel zur Längsachse) der Strömungswiderstand entsprechend hoch ist.

Die Erfindung umfasst ferner eine Anordnung. Die Anordnung wiederum vereint den beschriebenen Kühler und die zugehörige Leistungselektronik mit zumindest einem Leistungshalbleiter. Wie beschrieben ist die Leistungselektronik dabei auf dem Kühler angeordnet.

### Kurze Beschreibung der Zeichnung

Nachfolgend wird ein Ausführungsbeispiel der Erfindung unter Bezugnahme auf die begleitende Zeichnung im Detail beschrieben. In der Zeichnung ist:
- Figur 1: eine schematische Schnittansicht einer erfindungsgemäßen Anordnung mit erfindungsgemäßem Kühler gemäß einem Ausführungsbeispiel,
- Figur 2: eine schematische Draufsicht des erfindungsgemäßen Kühlers gemäß dem Ausführungsbeispiel,
- Figur 3: eine Draufsicht auf eine Kühlrippenanordnung des erfindungsgemäßen Kühlers gemäß dem Ausführungsbeispiel,
- Figur 4: eine Teilansicht der Kühlrippenanordnung aus Figur 3 und
- Figur 5: eine mehrteilige Ausgestaltung einer Kühlrippenanordnung.

### Ausführungsform der Erfindung

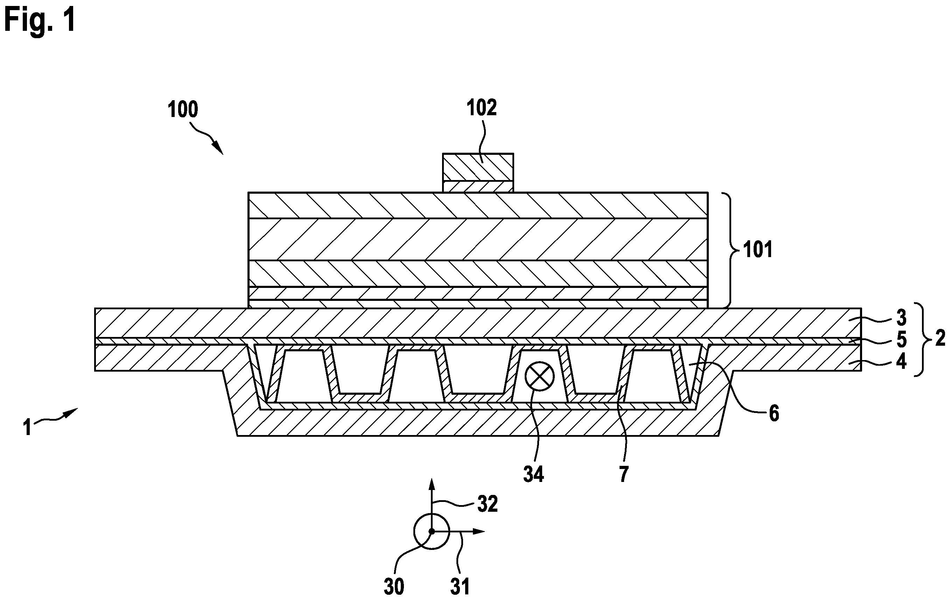

Im Folgenden wird eine Anordnung 100 mit einem Kühler 1 anhand der Figuren 1 bis 4 im Detail beschrieben. Die Anordnung 100 umfasst gemäß der schematischen Schnittansicht in Figur 1 eine Leistungselektronik 101, die auf dem Kühler 1 sitzt. Die Leistungselektronik 101 umfasst einen oder mehrere Leistungshalbleiter 102, die hier als primäre Wärmequellen betrachtet werden.

Gemäß den Figuren 1 bis 4 sind am Kühler 1 eine Längsachse 30, eine Querachse 31 und eine Hochachse 32 definiert. Die drei Achsen 30, 31 und 32 stehen jeweils senkrecht zueinander.

Ferner zeigt Figur 1, dass der Kühler 1 plattenförmig ausgebildet ist, mit zwei miteinander verbundenen und parallel angeordneten Kühlplatten 3, 5, die zusammen ein Gehäuse 2 des Kühlers 1 bilden. Zwischen den Kühlplatten 3, 4 befindet sich ein Kühlkanal 6. Die beiden Kühlplatten 3, 4 sind über eine Lotschicht 5 miteinander verbunden.

In dem Kühlkanal 6 befindet sich als Einlegeteil eine Kühlrippenanordnung 7, die ebenfalls über die Lotschicht mit dem Gehäuse 2 verbunden sein kann.

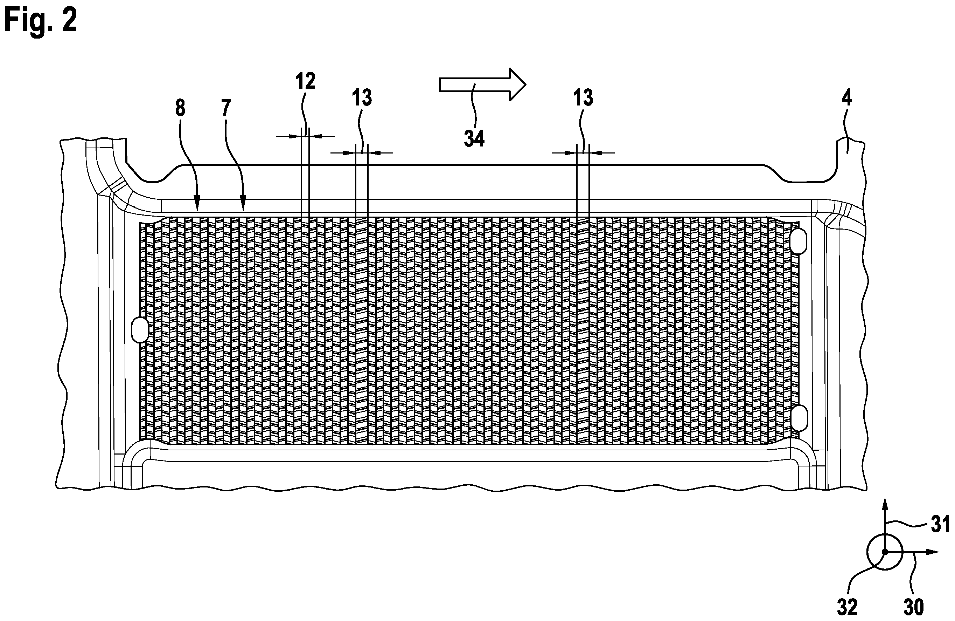

Figur 2 zeigt eine Draufsicht auf den Kühler 1. Die obere Kühlplatte 3 ist der Übersichtlichkeit halber ausgeblendet, so dass die untere Kühlplatte 4 mit darin aufgenommener Kühlrippenanordnung 7 zu sehen ist.

Das Gehäuse 2 ist zum Durchleiten eines kühlenden Fluides entlang einer Strömungsrichtung 34 ausgebildet. Bei der Strömungsrichtung 34, die sich parallel zur Längsachse 30 erstreckt, handelt es sich um die Hauptströmungsrichtung vom gehäuseseitigen Einlass zum gehäuseseitigen Auslass des Fluides. Innerhalb der Kühlrippenanordnung 7 kann das Fluid auch mit einer zur Querachse 31 parallelen Richtungskomponente fließen.

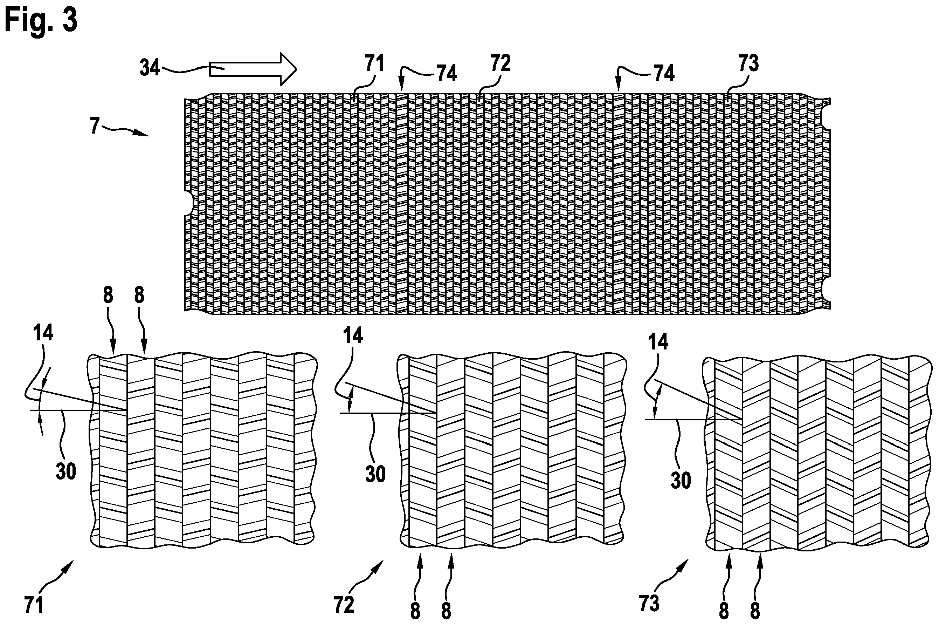

Figur 3 zeigt die Kühlrippenanordnung 7, welche sich entlang der Längsachse 30 bzw. entlang der Strömungsrichtung 34 aus einem ersten Kühlrippenabschnitt 71, einem zweiten Kühlrippenabschnitt 72 und einem dritten Kühlrippenabschnitt 73 zusammensetzt. Jeweils benachbarte Kühlrippenabschnitte 71 bis 73 sind über einen Zwischenabschnitt 74 fest miteinander verbunden. Auch die beiden Zwischenabschnitte 74 sind Bestandteil der Kühlrippenanordnung 7.

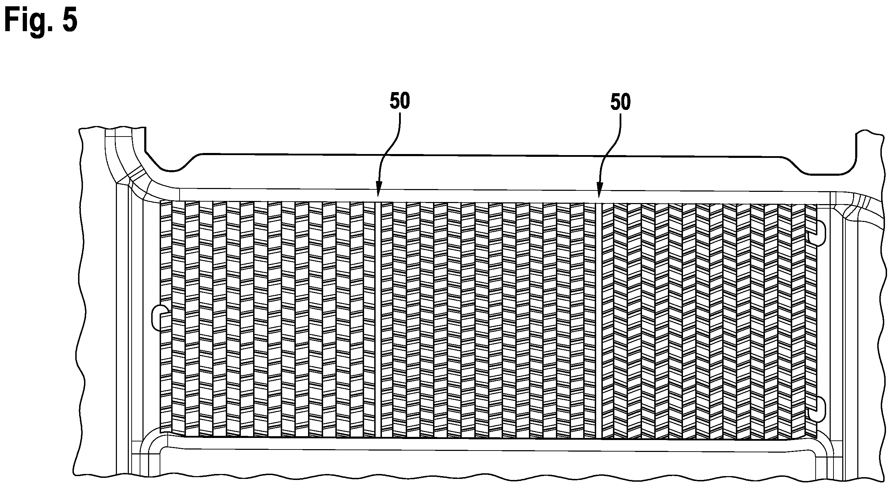

Die gesamte Kühlrippenanordnung 7 mit allen drei Kühlrippenabschnitten 71 bis 73 und den beiden Zwischenabschnitten 74 ist aus einem Blech gefertigt, das zu einem Turbulenzblech umgeformt ist. Demgegenüber zeigt Figur 5 eine mehrteilige Ausgestaltung der Kühlrippenanordnung 7. Wie Figur 5 zeigt, müssen bei dieser Ausgestaltung die einzelnen Turbulenzbleche mit einem Spalt 50 zueinander in die Kühlplatte 3 eingelegt werden. Dabei muss darauf geachtet werden, dass die einzelnen Turbulenzbleche nicht vertauscht oder verdreht werden. Des Weiteren muss der Spalt 50 eingehalten werden.

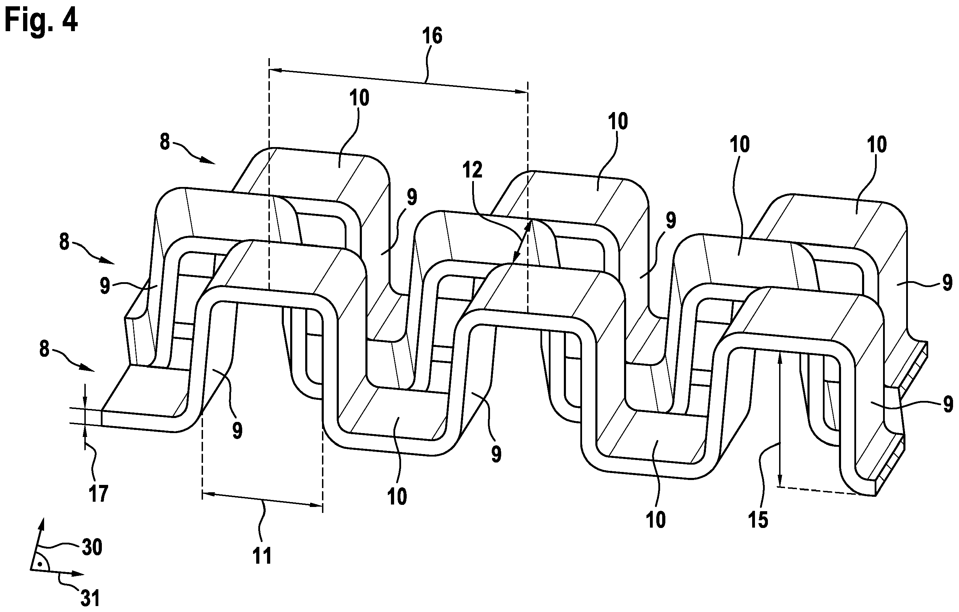

Im gezeigten Ausführungsbeispiel gemäß den Figuren 1 bis 4 setzt sich die Kühlrippenanordnung 7 aus einer Vielzahl an Rippenreihen 8 zusammen. Jede Rippenreihe 8 erstreckt sich entlang der Querachse 31. Entlang der Längsachse 30 hintereinander sind die Vielzahl an Rippenreihen 8 unmittelbar aneinander angrenzend angeordnet. Figur 4 zeigt in einer Detailansicht drei dieser Rippenreihen 8. Die einzelne Rippenreihe 8 ist dabei wellenförmig, wobei jeweils zwei benachbarte Rippen 9 durch einen Berg- oder Talabschnitt 10 der Wellenform miteinander verbunden sind. Parallel zur Querachse 31 ergibt sich dabei ein Abstand 11 zwischen zwei benachbarten Rippen 9. In der gleichen Richtung wird eine Periodenlänge 16 gemessen.

Die einzelne Rippe 9 erstreckt sich parallel zur Längsachse 30 über eine erste Länge 12. Entlang der Hochachse 32 ist eine Höhe 15 der Rippen 9 bzw. der Rippenreihen 8 definiert. Diese Höhe 15 entspricht auch der gesamten Höhe der Kühlrippenanordnung 7. Aus dem verwendeten Blech ergibt sich eine Materialstärke 17.

Figur 3 zeigt in Detaildarstellung die drei Kühlrippenabschnitte 71, 72 und 73. Dabei ist jeweils ein Anstellwinkel 14 der einzelnen Rippen 9 gegenüber der Längsachse 30 eingezeichnet. Die Richtung des Anstellwinkels 14 wechselt von einer Rippenreihe 8 zur benachbarten nächsten Rippenreihe 8 innerhalb eines Kühlrippenabschnitts 71, 72, 73.

Zur Erhöhung des Strömungswiderstandes entlang der Strömungsrichtung 34 ist vorgesehen, dass der Anstellwinkel 14 von dem ersten Kühlrippenabschnitt 71 zum zweiten Kühlrippenabschnitt 72 und vom zweiten Kühlrippenabschnitt 72 zum dritten Kühlrippenabschnitt 73 zunimmt.

Zusätzlich oder alternativ ist auch vorgesehen, dass die erste Länge 12, die die Erstreckung der Rippen 9 parallel zur Längsachse 30 beschreibt, von dem ersten Kühlrippenabschnitt 71 zum zweiten Kühlrippenabschnitt 72 und vom zweiten Kühlrippenabschnitt 72 zum dritten Kühlrippenabschnitt 73 abnimmt.

Die einzelnen Kühlrippenabschnitte 71, 72, 73 erstrecken sich entlang der Längsachse 30 vorzugsweise wesentlich länger als die beiden Zwischenabschnitte 74. Der jeweilige Zwischenabschnitt 74 ist vorzugsweise durch lediglich eine Rippenreihe 8 gebildet. Eine zweite Länge 13, die die Erstreckung des Zwischenabschnitts 74 entlang der Längsachse 30 beschreibt, ist vorzugsweise länger als die erste Länge 12 in den benachbarten Kühlrippenabschnitten 71, 72, 73.

Zur Veränderung des Strömungswiderstandes von einem Kühlrippenabschnitt zum nächsten Kühlrippenabschnitt können neben dem Anstellwinkel 14 und der ersten Länge 12 auch andere Geometrien der Rippen 9, beispielsweise der Abstand 11 oder die Höhe 15, verändert werden. Aus fertigungstechnischen Gründen bei der Herstellung des Turbulenzbleches durch Umformen ist jedoch bevorzugt vorgesehen, dass über die gesamte, aus einem Teil gefertigte Kühlrippenanordnung 7 die Periodenlänge 16 und somit der Abstand 11, die Höhe 15, und die Materialstärke 17 konstant gehalten werden.

## Patentansprüche

1. Kühler (1) zum Kühlen einer Leistungselektronik (101), umfassend
• ein Gehäuse (2) zum Aufsetzten der Leistungselektronik (101)
• und eine Kühlrippenanordnung (7) mit einer Vielzahl an Rippen (9) in einem Kühlkanal (6) des Gehäuses (2),
• wobei die Kühlrippenanordnung (7) entlang einer Längsachse (30) mit einem Fluid durchströmbar ist,
• wobei die Kühlrippenanordnung (7) mehrere Kühlrippenabschnitte (71, 72, 73) aufweist, wobei benachbarte Kühlrippenabschnitte unterschiedliche Geometrien der Rippen (9) aufweisen und wobei die Kühlrippenabschnitte (71, 72, 72) fest miteinander verbunden sind,
**dadurch gekennzeichnet, dass**
die Rippen (9) mit einem Anstellwinkel (14) zur Längsachse (30) angestellt sind und sich der Anstellwinkel (14) in zumindest zwei benachbarten Kühlrippenabschnitten (71, 72, 73) unterscheidet, wobei der Anstellwinkel (14) entlang der Strömungsrichtung von einem Kühlrippenabschnitt (71, 72, 73) zum nächsten Kühlrippenabschnitt (71, 72, 73) zunimmt.

2. Kühler nach Anspruch 1, wobei die Kühlrippenanordnung (7) aus einem Teil gefertigt ist.

3. Kühler nach Anspruch 2, wobei die Kühlrippenanordnung (7) durch Umformen eines Blechs zu einem Turbulenzblech gefertigt ist.

4. Kühler nach einem der vorhergehenden Ansprüche, wobei jeweils zwei benachbarte Kühlrippenabschnitte (71, 72, 73) mittels eines Zwischenabschnitts (74) der Kühlrippenanordnung (7) fest miteinander verbunden sind.

5. Kühler nach Anspruch 4, wobei in zumindest einem Kühlrippenabschnitt (71, 72, 73) die Rippen (9) eine erste Länge (12), gemessen parallel zur Längsachse (30), aufweisen und der benachbarte Zwischenabschnitt (74) eine zweite Länge (13), gemessen parallel zur Längsachse (30), aufweist, wobei die zweite Länge (13) größer ist als die erste Länge (12).

6. Kühler nach einem der vorhergehenden Ansprüche, wobei die Kühlrippenanordnung (7) eine konstante Materialdicke (17) und/oder eine konstante Rippenhöhe (15) und/oder eine konstante Periodenlänge (16) aufweist.

7. Kühler nach einem der vorgehenden Ansprüche, wobei die Rippen (9) eine erste Länge (12) parallel zur Längsachse (30) aufweisen und sich die erste Länge (12) von einem Kühlrippenabschnitt (71, 72, 73) zum nächsten Kühlrippenabschnitt (71, 72, 73) verringert.

8. Anordnung (100) umfassend einen Kühler (1) nach einem der vorhergehenden Ansprüche und eine Leistungselektronik (101) mit mehreren Leistungshalbleitern (102), die auf dem Gehäuse (2) angeordnet sind.

## Claims

1. Cooler (1) for cooling power electronics (101), comprising
• a housing (2) for attaching the power electronics (101)
• and a cooling fin arrangement (7) having a multiplicity of fins (9) in a cooling channel (6) of the housing (2),
• wherein the cooling fin arrangement (7) is able to be flowed through by a fluid along a longitudinal axis (30),
• wherein the cooling fin arrangement (7) has a plurality of cooling fin sections (71, 72, 73), wherein adjacent cooling fin sections have different geometries of the fins (9) and wherein the cooling fin sections (71, 72, 72) are fixedly connected to one another,
**characterized in that**
the fins (9) are set at an angle of incidence (14) with respect to the longitudinal axis (30) and the angle of incidence (14) differs in at least two adjacent cooling fin sections (71, 72, 73), wherein the angle of incidence (14) increases along the flow direction from one cooling fin section (71, 72, 73) to the next cooling fin section (71, 72, 73).

2. Cooler according to Claim 1, wherein the cooling fin arrangement (7) is produced from one part.

3. Cooler according to Claim 2, wherein the cooling fin arrangement (7) is produced by shaping a metal sheet to form a turbulence sheet.

4. Cooler according to one of the preceding claims, wherein in each case two adjacent cooling fin sections (71, 72, 73) are fixedly connected to one another by means of an intermediate section (74) of the cooling fin arrangement (7).

5. Cooler according to Claim 4, wherein in at least one cooling fin section (71, 72, 73) the fins (9) have a first length (12), measured parallel to the longitudinal axis (30), and the adjacent intermediate section (74) has a second length (13), measured parallel to the longitudinal axis (30), wherein the second length (13) is greater than the first length (12).

6. Cooler according to one of the preceding claims, wherein the cooling fin arrangement (7) has a constant material thickness (17) and/or a constant fin height (15) and/or a constant period length (16).

7. Cooler according to one of the preceding claims, wherein the fins (9) have a first length (12) parallel to the longitudinal axis (30) and the first length (12) decreases from one cooling fin section (71, 72, 73) to the next cooling fin section (71, 72, 73).

8. Arrangement (100) comprising a cooler (1) according to one of the preceding claims and power electronics (101) having a plurality of power semiconductors (102) which are arranged on the housing (2).

## Revendications

1. Refroidisseur (1) destiné à refroidir une électronique de puissance (101), comprenant
• un boîtier (2) servant à poser l'électronique de puissance (101)
• et un arrangement d'ailettes de refroidissement (7) avec une pluralité d'ailettes (9) dans un canal de refroidissement (6) du boîtier (2),
• l'arrangement d'ailettes de refroidissement (7) pouvant être traversé par un fluide le long d'un axe longitudinal (30),
• l'arrangement d'ailettes de refroidissement (7) possédant plusieurs portions d'ailettes de refroidissement (71, 72, 73), des portions d'ailettes de refroidissement voisines présentant des géométries différentes des ailettes (9) et les portions d'ailettes de refroidissement (71, 72, 72) étant reliées à demeure les unes aux autres,
**caractérisé en ce que**
les ailettes (9) sont placées avec un angle d'inclinaison (14) par rapport à l'axe longitudinal (30) et l'angle d'inclinaison (14) diffère dans au moins deux portions d'ailettes de refroidissement (71, 72, 73) voisines, l'angle d'inclinaison (14) augmentant le long de la direction d'écoulement d'une portion d'ailettes de refroidissement (71, 72, 73) à la portion d'ailettes de refroidissement (71, 72, 73) suivante.

2. Refroidisseur selon la revendication 1, l'arrangement d'ailettes de refroidissement (7) étant fabriqué d'une seule pièce.

3. Refroidisseur selon la revendication 2, l'arrangement d'ailettes de refroidissement (7) étant fabriqué par formage d'une tôle en une tôle de turbulence.

4. Refroidisseur selon l'une des revendications précédentes, deux portions d'ailettes de refroidissement (71, 72, 73) voisines étant respectivement reliées à demeure entre elles au moyen d'une portion intermédiaire (74) de l'arrangement d'ailettes de refroidissement (7).

5. Refroidisseur selon la revendication 4, les ailettes (9), dans au moins une portion d'ailettes de refroidissement (71, 72, 73), présentant une première longueur (12) mesurée parallèlement à l'axe longitudinal (30), et la portion intermédiaire (74) voisine présentant une deuxième longueur (13) mesurée parallèlement à l'axe longitudinal (30), la deuxième longueur (13) étant supérieure à la première longueur (12).

6. Refroidisseur selon l'une des revendications précédentes, l'arrangement d'ailettes de refroidissement (7) présentant une épaisseur de matériau (17) constante et/ou une hauteur d'ailette (15) constante et/ou une longueur de période (16) constante.

7. Refroidisseur selon l'une des revendications précédentes, les ailettes (9) présentant une première longueur (12) parallèle à l'axe longitudinal (30) et la première longueur (12) diminuant d'une portion d'ailettes de refroidissement (71, 72, 73) à la portion d'ailettes de refroidissement (71, 72, 73) suivante.

8. Arrangement (100) comprenant un refroidisseur (1) selon l'une des revendications précédentes et une électronique de puissance (101) comportant plusieurs semi-conducteurs de puissance (102) qui sont disposés sur le boîtier (2).
